# EUROPEAN PATENT APPLICATION

(11) **EP 4 748 579 A1**
(43) Date of publication of application: **27.05.2026**
(21) Application number: 25216411.6
(22) Date of filing: 17.11.2025
(51) Int. Cl.: B41J 2/175

(54) **LIQUID-EJECTION-HEAD PACKAGE**

(30) Priority: 26.11.2024 JP 2024205847
(71) Applicant: Canon Kabushiki Kaisha, Tokyo 146-8501 (JP)
(72) Inventor: ISHIMATSU, Shin, Tokyo 146-8501 (JP)
(74) Representative: Canon Europe Limited

(57) **Abstract**

A liquid-ejection-head package (100) includes a liquid ejection head (1) to be included in a liquid ejection apparatus (50) and configured to eject liquid, a humidity controlling agent (32), and an envelope (31) accommodating the liquid ejection head (1) and the humidity controlling agent (32).

## Description

### TECHNICAL FIELD

The present disclosure relates to a liquid-ejection-head package.

### BACKGROUND

A liquid ejection head detachably attached to a liquid ejection apparatus such as an inkjet printer and configured to eject liquid tends to be packaged separately from the liquid ejection apparatus during logistics. Even in a case where a liquid ejection head is set in a recording apparatus in advance, a replacement liquid ejection head is packaged separately.

For logistics of such a liquid ejection head, a liquid that is different from the ink to be usually used in recording may be filled into ink flow paths, particularly into nozzles communicating with ejection ports. However, a transparent liquid different from ink is difficult to keep in a constant condition and to manage without causing leakage. Therefore, in some cases, the liquid inside the liquid ejection head may be completely removed before being packaged for transport.

In general, liquid ejection heads are packaged in a hermetic manner so as to avoid the influence of any environments such as the one containing corrosive gas and/or the one prone to dust adhesion. However, if a liquid ejection head is hermetically packaged while any liquid such as a cleaning solution used in the manufacture of the head remains inside, the humidity inside the package gradually increases and may eventually reach almost 100 RH%. If a liquid ejection head is stored at a high humidity for a long time during logistics or any other process, metal members included in the liquid ejection head, such as metal contact pads on an electric circuit board, may corrode. Such a problem is particularly pronounced in the case of a large-sized liquid ejection head having a complicated flow-path configuration.

Furthermore, regarding a liquid ejection head including a piezoelectric device serving as a pressure application component for liquid ejection, the piezoelectric device is known to deteriorate with moisture. A piezoelectric device disclosed in Japanese Patent Laid-Open Publication No. 2011-131549 includes a humidity retaining component for suppressing the deterioration of the piezoelectric device due to moisture.

However, addressing only the humidity fluctuation occurring in the piezoelectric device as disclosed in Japanese Patent Laid-Open Publication No. 2011-131549 is not reliable enough to reduce the corrosion risks in other situations, for example, in a logistics environment for heads where temperature changes significantly.

### SUMMARY

The present disclosure is directed to a liquid-ejection-head package that provides a reliable liquid ejection head.

The present disclosure in its first aspect provides a liquid-ejection-head package as specified in claim 1. Optional features are specified in claims 2 to 18.

Features of the present disclosure will become apparent from the following description of embodiments with reference to the attached drawings. The following description of embodiments is described by way of example.

### BRIEF DESCRIPTION OF THE DRAWINGS

Fig. 1 is a schematic configuration diagram of a liquid ejection apparatus.
Fig. 2 is a perspective view of the liquid ejection head.
Fig. 3 is an exploded perspective view of the liquid ejection head illustrated in Fig. 2.
Fig. 4 is a schematic sectional view of an ejection-device substrate.
Fig. 5 is a schematic perspective view of a liquid-ejection-head package according to the present disclosure.
Fig. 6 is a graph illustrating temperature change occurring inside an envelope under Condition 1-1 in Example 1.
Fig. 7 is a graph illustrating temperature change occurring inside an envelope under Condition 1-5 in Example 1.

### DESCRIPTION OF THE EMBODIMENTS

Examples of embodiments of the present disclosure will now be described with reference to the attached drawings. Note that the following description does not limit the scope of the present disclosure. While the following description provides one example of a liquid ejection head employing a thermal scheme in which liquid is ejected with the use of bubbles generated by a heating device, the present disclosure is also applicable to a liquid ejection head employing any other liquid ejection scheme such as a piezo scheme in which a piezoelectric device is used.

### Configuration of Liquid Ejection Apparatus

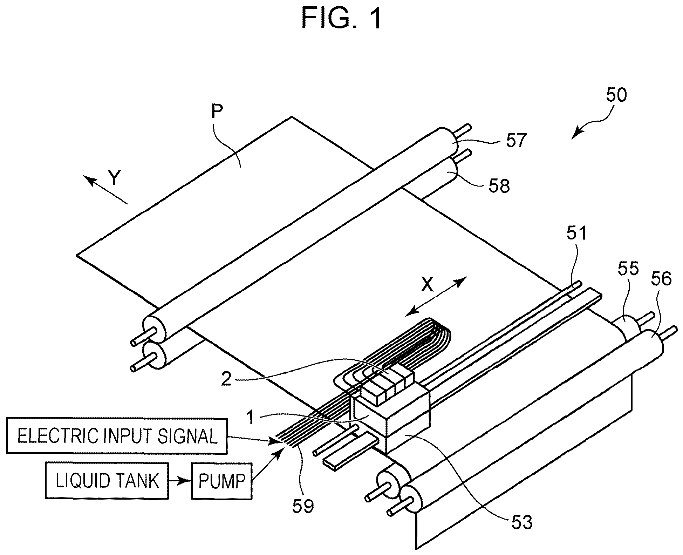

Fig. 1 is a schematic configuration diagram of a liquid ejection apparatus 50 including a liquid ejection head 1. The liquid ejection apparatus 50 is an inkjet apparatus configured to eject liquid such as ink from the liquid ejection head 1 to a medium P. The liquid ejection head 1 is mounted on a carriage 53. The carriage 53 is configured to move back and forth in a main scanning direction, indicated by arrow X, along a guide shaft 51. The medium P is conveyed by conveying rollers 55, 56, 57, and 58 in a sub scanning direction, indicated by arrow Y, intersecting (orthogonal to, in the present embodiment) the main scanning direction.

The liquid ejection head 1 includes circulation units 2, the number of which corresponds to the number of liquids (inks) to be ejected. The liquids are supplied individually. Electrical wires necessary for liquid ejection and pipes for the liquids and air are connected to the carriage 53 through a guide 59. A cap member (not illustrated) is provided at a position away from the conveyance path for the medium P. When the liquid ejection head 1 is not performing ejection, the liquid ejection head 1 moves to such a position that the cap member covers the face of the liquid ejection head 1, for the prevention of drying of ejection ports or for the performance of suction before refilling or recovery.

### Configuration of Liquid Ejection Head

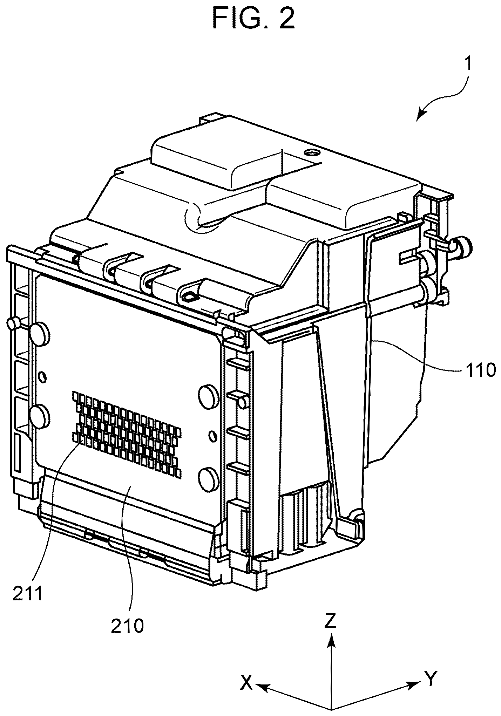

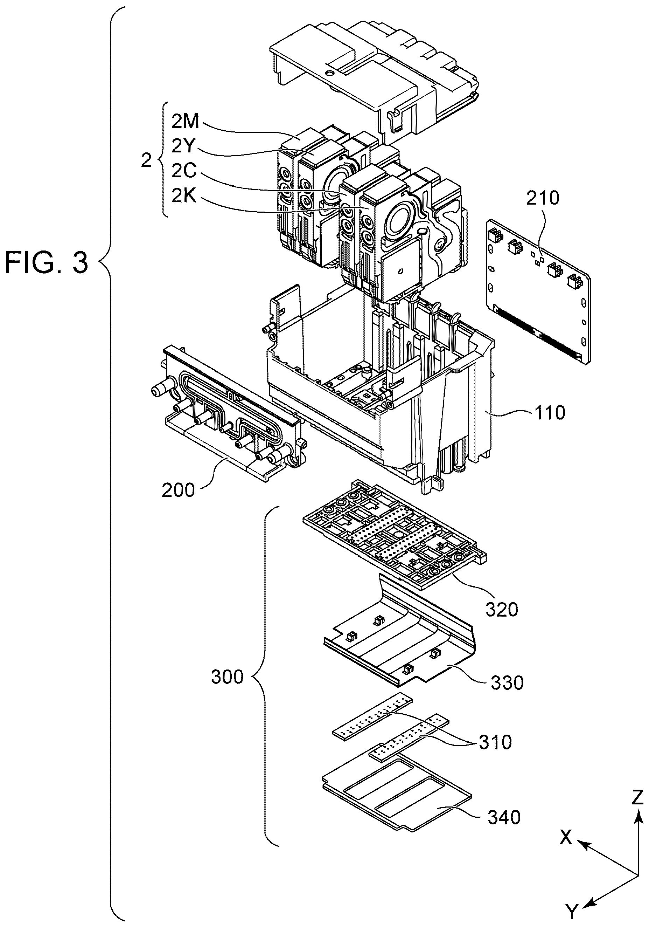

Fig. 2 is a perspective view of the liquid ejection head 1. Fig. 3 is an exploded perspective view of the liquid ejection head 1 illustrated in Fig. 2. As illustrated in Fig. 3, the liquid ejection head 1 includes the circulation units 2. The circulation units 2 are a plurality of circulation units 2M, 2Y, 2K, and 2C provided in correspondence with different inks of magenta, yellow, black, and cyan. The circulation units 2 are individually connected to a flow-path member 110.

The circulation units 2 and the flow-path member 110 are connected to each other by any way, such as screwing with a seal member interposed in between, or fusion bonding. A connection member 200 is connected to the flow-path member 110. The connection member 200 is configured to receive the liquids from liquid tanks (not illustrated) provided in the liquid ejection apparatus 50. The connection member 200 is connected to and communicates with the individual circulation units 2M, 2C, 2Y, and 2K.

The liquid tank and the connection member 200 are connected to each other through supply tubes (not illustrated) provided for the respective liquids (inks) to be ejected. The inks supplied through the supply tubes flow through the connection member 200 connected to the flow-path member 110 and are supplied to the respective circulation units 2. That is, the circulation units 2 each serve as a supply unit. An ejection unit 300 is connected to the bottom surface of the flow-path member 110. The inks supplied to the circulation units 2 are supplied to the ejection unit 300 through the flow-path member 110. The inks are caused to circulate between the ejection unit 300 and the circulation units 2M, 2C, 2Y, and 2K.

The ejection unit 300 includes an ejection-device substrate 310, a supporting member 320, a flexible wiring board 330, and a cover member 340. The ejection-device substrate 310 is provided with ejection devices (actuators) configured to eject the inks. The flexible wiring board 330 is configured to send electric signals to the ejection devices. The cover member 340 covers the flexible wiring board 330. The ejection-device substrate 310 and the flexible wiring board 330 are bonded to the supporting member 320. The flexible wiring board 330 is bonded on a side of the supporting member 320 where the ejection-device substrate 310 is bonded, avoiding an area where the ejection-device substrate 310 is bonded. The flexible wiring board 330 is bonded to the supporting member 320 after being bent in conformity with the supporting member 320. In other embodiments, other means of fixation may be used, for example with fasteners, for detachable attachment.

An adhesive or sealant is provided between the supporting member 320 and the flexible wiring board 330 provided thereon, whereby the bonding strength is increased and the deterioration in the reliability due to ink entry is prevented.

The ejection-device substrate 310 and the flexible wiring board 330 are electrically connected to each other by wire bonding. Any other way of electrical connection such as flying lead bonding may be employed. The cover member 340 has an opening at a position corresponding to the ejection-device substrate 310. The connection between the ejection unit 300 and the flow-path member 110 may be implemented by any way, such as bonding with an adhesive, or screwing with a sealing member interposed between the two.

A surface of the flow-path member 110 that is opposite the surface on which the connection member 200 is provided is a contact surface at which the flow-path member 110 is to be in contact with a liquid-ejection-apparatus body and to which an electrical wiring board 210 is connected. The electrical wiring board 210 is configured to receive electric signals from the liquid-ejection-apparatus body. Electrode portions (pad portions) 211 are metal surfaces included in the electrical wiring board 210. The electrode portions 211 are connected to electrode portions that are metal surfaces included in the carriage 53, whereby power and electric signals are received from the liquid-ejection-apparatus body. The electric signals and the like thus received are sent from the electrical wiring board 210 to the ejection unit 300 and through the flexible wiring board 330 to the ejection-device substrate 310.

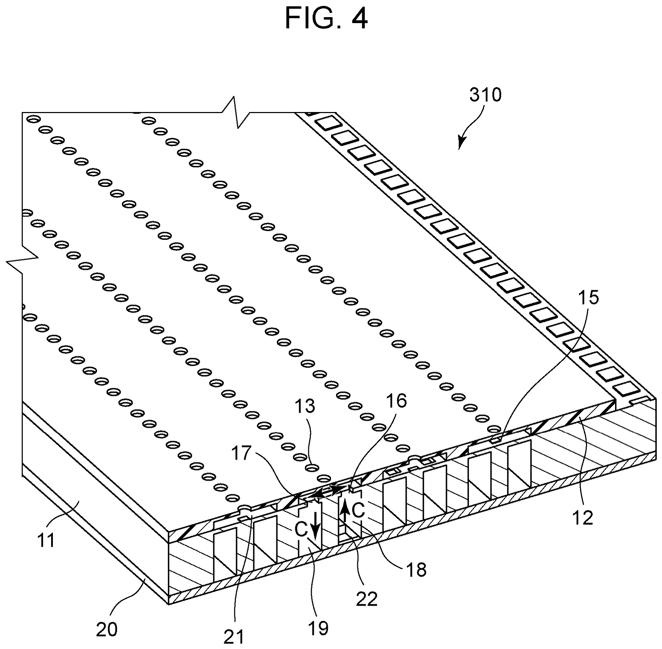

Fig. 4 is a sectional view of the ejection-device substrate 310. The ejection-device substrate 310 includes a substrate 11 made of silicon, and an ejection-port member 12 made of a photosensitive resin and provided on one face of the substrate 11, and a lid member 20 bonded to the other face of the substrate 11. The substrate 11 comprises liquid supply paths 18 and liquid collection paths 19. The substrate may have the liquid supply paths 18 and the liquid collection paths 19 formed therein. The liquid supply paths and liquid collection paths may be arranged along ejection-port rows each being a row of ejection ports 13. The liquid supply paths 18 and the liquid collection paths 19 provided between the substrate 11 and the lid member 20 are connected to flow paths provided in the supporting member 320 through openings 22 provided in the lid member 20. A pressure difference is produced between the liquid supply paths 18 and the liquid collection paths 19. Therefore, while liquid is being ejected from any of the ejection ports 13, the pressure difference causes the liquid at the remaining ejection ports 13 that are not in use for ejection to flow as illustrated by arrows C in Fig. 4. Specifically, the liquid in the corresponding liquid supply path 18 provided in the substrate 11 flows through a supply port 16, a pressure chamber 21, and a collection port 17 into the corresponding liquid collection path 19.

### Print Test Process and Packaging Process for Liquid Ejection Head

The liquid ejection head 1 has a complicated liquid-flow-path configuration described above. Therefore, in general, whether liquid ejection from the ejection ports 13 is normally performable, i.e. during normal use after manufacture, is checked through a print (ejection) test during manufacture. To conduct the print test, the liquid ejection head 1 is filled with liquid (ink) intended for actual ejection or liquid (ink) intended for test, and the ejection devices 15 are activated. If the liquid ejection head 1 remains filled with the liquid even after the print test, some quality problems such as liquid leakage, degeneration, and/or deposition of colorant of test ink or the like on the flow-path member 110 may occur depending on the logistics environment thereafter. Hence, after the liquid (ink) used in the test is removed from the liquid ejection head 1 to some extent, the liquid ejection head 1 is filled with pure water or the like, whereby the flow paths are cleansed. After the pure water is removed from the liquid ejection head 1 to some extent, the flow paths are dried by feeding compressed dry air or the like into the flow paths (air-blowing).

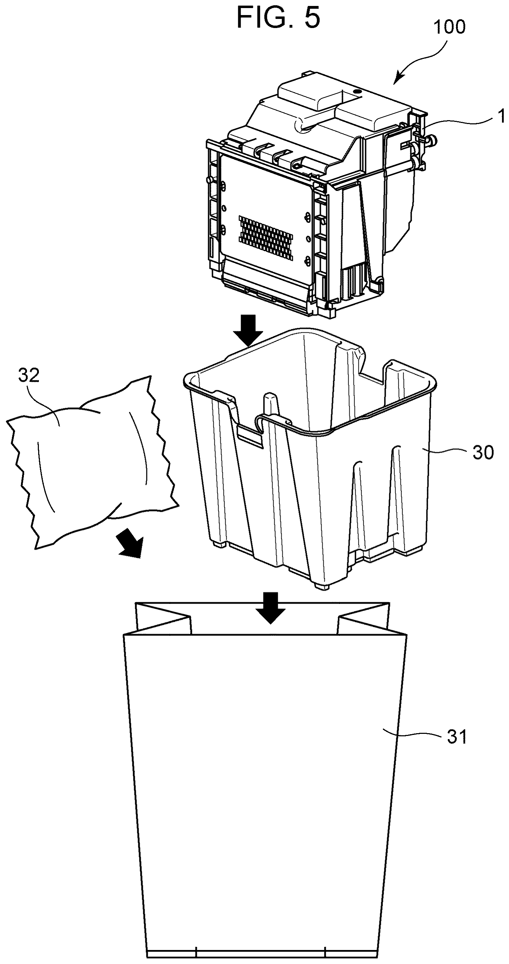

The liquid ejection head 1 once dried is put into a head case (denoted by reference sign 30 in Fig. 5) or the like so that any impact due to dropping or the like during logistics is eased. To avoid the influence of outgassing in the logistics environment, the head case having the liquid ejection head 1 inside is put into an envelope (pillow bag) (denoted by reference sign 31 in Fig. 5), and the envelope is sealed by thermal fusion bonding.

### Process of Collecting Liquid Ejection Head

Depending on the frequency of use (printing) of the liquid ejection apparatus or if any problem occurs in the liquid ejection apparatus, the liquid ejection head may be replaced. In such a situation, a field service technician from the manufacturer brings a fresh liquid ejection head in a packaged form to the user. Then, the field service technician may open an envelope having the fresh liquid ejection head inside and replace the liquid ejection head that has been used in the liquid ejection apparatus (hereinafter also referred to as a used head) with the fresh one. The used head is put into a head case that has been used for the fresh liquid ejection head and is put into the opened envelope that has been used for the fresh one, and the resulting package is collected for or sent to the manufacturer. The used head thus collected is processed in, for example, a collection facility so as to be treated for reuse, recycling of components, and/or the like. Hereinafter, as a matter of convenience of description, a period after the removal of the used head from the liquid ejection apparatus until the collection of the used head to the facility is referred to as a collection logistics process.

In the collection logistics process, the liquid ejection head contains ink to some extent. Such a liquid ejection head is rarely cleansed before collection. Some kinds of liquid, such as ink, to be ejected may emit not only vapor but also corrosive gas. In that case, if an envelope having the liquid ejection head inside is hermetically sealed by fusion bonding in the collection logistics process, some metal elements of the liquid ejection head such as contact pads may corrode. Corroded metal components cannot be reused. Therefore, to avoid the containment of corrosive gas and the state of high humidity due to vapor generation in a hermetically sealed space, it may be considered to collect the liquid ejection head with the envelope not sealed by fusion bonding. In that case, however, any ink leaked from the liquid ejection head may leak to the outside of the envelope. Moreover, the head case and/or the liquid ejection head may pop out of the envelope.

The containment of corrosive gas and the state of high humidity due to vapor generation may be avoided by making a hole in the envelope to allow humidity and corrosive gas to migrate from inside the envelope. However, if the hole is provided in a part which is sealed, for example, by fusion bonding, there is a possibility that corrosive gas or vapor may fill the inside of the envelope because the hole is either sealed or significantly occluded. That is, the collection logistics process may also involve a problem similar to that occurring in the case of logistics of fresh liquid ejection heads. That is to say, this problem may occur with both used liquid ejection heads being returned and fresh (newly manufactured) liquid ejection heads being sent.

Fig. 5 is a schematic perspective view of a liquid-ejection-head package 100 according to the present embodiment. The package 100 includes the liquid ejection head 1, a humidity controlling agent 32, and an envelope 31. The envelope 31 accommodates the liquid ejection head 1 and the humidity controlling agent 32. The humidity controlling agent 32 will be described separately below. The package 100 according to the present embodiment further includes a head case 30, which accommodates the liquid ejection head 1. The head case 30 plays a role of fixedly holding the liquid ejection head 1 and a role of protecting the liquid ejection head 1 from any impact at the time of accidental dropping, vibrations, and the like that may occur, for example, during logistics. The envelope 31 has a bag shape that allows the head case 30 having the liquid ejection head 1 inside to be bagged. From a viewpoint of liquid resistance and moisture resistance, a typical envelope is made of a material having a gas-barrier capability. Examples of such a material include aluminum and multilayer film.

In the present embodiment, the head case 30 having the liquid ejection head 1 inside and the humidity controlling agent 32 are put together into the envelope 31, and the opening of the envelope 31 is hermetically sealed by thermal fusion bonding. The humidity controlling agent 32 according to the present embodiment has a shape obtained by wrapping a humidity controlling material in a wrapping paper (or film).

The humidity controlling agent 32 may include a material effective for controlling the humidity in a given space within a specific range (a humidity controlling material). Examples of such a material include type-B silica gel, silica-alumina gel, and/or zeolite. In terms of cost and stability, type-B silica gel is most suitable. For example, silica-alumina gel is more expensive than type-B silica gel and tends to have an unstable shape when wet, which may limit options for the material (paper or film) for wrapping the humidity controlling material and/or the number of provision locations for the humidity controlling agent 32 inside the package. Zeolite has a shape that is neither spherical nor constant and may therefore tear the wrapping paper. In the logistics process, impact, for example, due to dropping and/or vibration, may occur and be applied to the liquid ejection head in the packaged state, i.e. the package comprising the envelope, liquid ejection head inside the envelope and humidity controlling agent. If such an impact is of sufficient force there may be a risk of damaging, e.g. shatter or ripping, the humidity controlling material or paper bag (wrapper) which cause the material to leak from the wrapping paper bag. Once the material is leaked from the wrapping paper, there is a risk that it adheres to the ejection ports 13, leading to the limitation of options for the wrapping paper and the limitation of the number of provision locations for the humidity controlling agent 32.

The humidity controlling agent 32 is desired to adjust the humidity inside the envelope 31 to a relative humidity of 60% or below. This is because in general a relative humidity above 60% rapidly promotes the corrosion of metal. Preferably, the humidity controlling agent 32 is desired to adjust the humidity inside the envelope 31 to a relative humidity of 5% or above and 60% or below, that is to say a relative humidity in the range for around 5% to around 60%. This is to suppress excessive drying of the liquid ejection head 1.

To satisfy the above preferable range of humidity, the humidity controlling agent 32 is preferred to include both a material effective for the above humidity control and a material effective for drying. Example of the drying agent include type-A silica gel, calcium chloride, and/or quicklime. Among these, type-A silica gel is found to be most suitable in terms of cost and stability. Taking calcium chloride as a comparative example, calcium chloride is deliquescent and may cause liquid matter to scatter in a logistics environment that involves impacts due to vibration and dropping, leading to the limitation of options for the wrapping paper, the limitation of the number of provision locations for the humidity controlling agent 32, and a cost increase accompanying the limitations. In another comparative example, quicklime generates heat and causes volume increase by absorbing moisture. Depending on the logistics environment, the ambient temperature may reach 70°C. Therefore, depending on the deflection temperature under excessive load for the resin member included in the liquid ejection head 1, the number of provision locations may be limited. To be more specific, if quicklime having a heat-generating characteristic is placed near a liquid ejection head 1 or head case 30 that includes a resin whose deflection temperature under excessive load is 70°C, the surface temperature of the resin may exceed 70°C, leading to a deformation of the resin. In particular, if polypropylene whose deflection temperature under excessive load is in general 57°C to 70°C is used for the head case, quicklime is not suitable as a humidity controlling agent.

The most suitable material as the humidity controlling agent 32 that is effective for both humidity control and drying is a mixture of type-B silica gel and type-A silica gel. In general, in an environment at a humidity of 65% or below, type-A silica gel has a higher coefficient of moisture absorption than type-B silica gel. On the other hand, in an environment at a humidity of 65% or above, type-B silica gel has a higher coefficient of moisture absorption than type-A silica gel. That is, type-A silica gel exerts higher moisture absorption in an environment at a humidity of 65% or below, whereas type-B silica gel exerts higher moisture absorption in an environment at a humidity of 65% or above. Putting type-A silica gel and type-B silica gel together in a single envelope 31 suppresses the increase in humidity because humidity is absorbed in a range of relative humidity of 60% or above in which metal corrosion rapidly progresses and in a range of relative humidity of 60% to 65% in which the speed of moisture absorption by type-B silica gel decreases. That is the combination of type-B and type-A silica provides a way to ensure that one silica type compensates for a reduction in moisture absorption of the other silica type.

The appropriate humidity range for precision-instrument facility is 40% to 50%, within which packaging of heads together with air tends to be performed. Considering that type-B silica gel exerts its moisture absorption to some extent in an environment at a relative humidity of 60% or below and that type-A silica gel is present around the type-B silica gel, the type-B silica gel is assumed to be placed in a space at a moderately low humidity, not in an environment at an excessively low humidity of 0% to 5%. To place type-B silica gel in a low-humidity space, type-A silica gel needs to be placed as close to type-B silica gel as possible. Therefore, a mixture of type-B silica gel and type-A silica gel is desired to be wrapped in a single wrapper. It may also be desirable for the type-B silica gel and type-A silica gel to be wrapped in a single wrapper together when the environment is below 60% relative humidity, preferably when the environment is in the range of 60% and 5% relative humidity. However, the use of the combination of type-B silica gel and type-A silica gel in this disclosure may not be limited in such a way for all embodiments.

Another humidity controlling characteristic of type-B silica gel is as follows. If type-B silica gel having been in an environment at a relative humidity of 40% is moved into a space at a relative humidity of 20%, the type-B silica gel acts to keep the relative humidity in the space between 40% and 20%. On the other hand, if type-B silica gel in an environment at a relative humidity of 40% is moved to a space at a relative humidity of 60%, the type-B silica gel acts to keep the relative humidity in the space between 60% to 40%.

At room temperature, type-A silica gel does not exhibit the above reversibility.

In a packaging form for an inkjet apparatus, preferably a liquid ejection head for use in an inkjet apparatus, the relative humidity inside the envelope 31 is desired to be 60% or below, however, an almost completely dry state with a relative humidity of 5% or below is not desirable. With a mixture of type-A silica gel and type-B silica gel, an environment at an excessively low humidity of 0% to 5% is not produced. In other words, there is no possibility of excessive dryness. Hence, there is no problem with setting the weight of the humidity controlling agent 32 provided for moisture absorption to a value greater than the amount of moisture inside the liquid ejection head 1. The ratio of weight of humidity controlling agent to weight of moisture inside liquid ejection head may favor the weight of humidity controlling agent.

The maximum amount of moisture absorption by 1 g of the humidity controlling agent 32 is 0.5 g. This value is achieved when silica gel is caused to absorb moisture for a long time and to the extremity. To assuredly eliminate or significantly reduce the possibility of metal corrosion in the liquid ejection head 1 in the logistics environment, it is insufficient that the humidity is reduced over a long time, but it is important for the liquid ejection head 1 not to experience a relative humidity of 60%. Accordingly, the amount of the humidity controlling agent 32 is desired to be adjusted such that the maximum amount of moisture absorption by the humidity controlling agent 32 becomes greater than or equal to ten times the amount of moisture contained inside the liquid ejection head 1. Alternatively, the weight of the humidity controlling agent 32 is desired to be made greater than or equal to five times the maximum amount of moisture absorption.

It is difficult to estimate how temperature changes in a logistics environment. Therefore, it is difficult to estimate the humidity inside the envelope 31. Hence, it is important to maintain a satisfactory speed of moisture absorption by the humidity controlling agent 32 over the entire range of humidity, and it is desirable that the ratio of mixture of type-A silica gel and type-B silica gel be 1:1. Furthermore, the value of (weight of type-B silica gel)/(weight of type-A silica gel) only needs to be 0.8 or greater and 1.2 or smaller. In other words, it is preferable that the ratio of the weight of type-B silica gel to the weight of type-A silica gel be 0.8 or greater and 1.2 or smaller. If the weight of the humidity controlling agent 32 is set to a value greater than or equal to five times the maximum amount of moisture absorption as described above, the variation in the weight ratio (between type-A silica gel and type-B silica gel) does not affect the function of the humidity controlling agent 32. If existing type-A silica gel or type-B silica gel distributed in packs each having a specific weight is used, the weight ratio of the two may be selected as appropriate.

The humidity controlling agent 32 absorbs vapor and corrosive gas inside the envelope 31. However, if the envelope 31 has a poor gas-barrier capability, the humidity controlling agent 32 having a high absorption capability may absorb through the envelope 31 vapor and/or corrosive gas that is present outside the envelope 31. Hence, the envelope 31 is desired to have a high gas-barrier capability and is desired to be made of a material on which aluminum is deposited or laminated. Regarding type-B silica gel, the absorption of vapor is reversible, whereas the absorption of corrosive gas is not reversible. With such a characteristic of type-B silica gel, a material that has been difficult to use because of the generation of corrosive gas becomes usable for the envelope 31 and/or the head case 30. Examples of the material for the head case and/or envelope include recycled plastic and pulp mold. In particular, pulp mold is advantageous in the absorption of ink leaked, if any, from the liquid ejection head 1. However, pulp mold may be softened when exposed to vapor in a highly humid environment, leading to possible loss of the original role as the envelope 31 and/or the head case 30 of absorbing impact. In view of such circumstances, if the humidity controlling agent 32 is put into an envelope 31 made of pulp mold as in the present embodiment, the pulp mold is enabled to keep having satisfactory hardness.

Thus, the package according to the present disclosure enables the provision of a highly reliable liquid ejection head. Furthermore, the package eliminates the necessity of a protective member (such as a face cover or gold plating on the contact pads) for a specific element that has been provided in consideration for the influence of humidity. Furthermore, components including metal are prevented from corrosion. Furthermore, a resin material that has been exposed to moisture is prevented from deterioration, and other problems such as adhesion of liquid inside the flow paths and excessive thickening of liquid are also suppressed. If the present disclosure is applied to a liquid ejection head employing a piezoelectric ejection scheme, the effect of suppressing the deterioration of piezoelectric devices due to moisture is obtained in a favorable manner.

Furthermore, since the humidity inside the envelope is kept constant by the humidity controlling agent, a material that has been difficult to use because of the influence of humidity becomes usable (for example, a head case made of pulp mold). Furthermore, the effect of absorbing corrosive outgas enables the use of a recycled resin or the like as a material for elements such as the packaging member and the head case.

The present disclosure is also suitably applicable to a liquid ejection head that is filled with a liquid, such as clear ink, dedicated to logistics, that is to say, a liquid which is used during logistic processes.

The package according to the present disclosure is also applicable to the process of collecting the liquid ejection head from the user.

In such an application, the reliability of individual components of the collected liquid ejection head is increased, and the recycling of the collected liquid ejection head and components included therein is facilitated. Depending on the kind of the humidity controlling agent, the humidity controlling agent itself is recyclable or is easily disposable as inflammables.

### Other Embodiments

The present disclosure is not limited to the above embodiment and examples to be described below and can be modified in various ways within the technical idea thereof. For example, different embodiments and/or examples may be combined in their entirety or in part.

The present disclosure encompasses the following configurations.

### (Configuration 1)

A liquid-ejection-head package comprising:
a liquid ejection head configured to be included in a liquid ejection apparatus and configured to eject liquid;
a humidity controlling agent; and
an envelope accommodating the liquid ejection head and the humidity controlling agent.

### (Configuration 2)

The package according to configuration 1, wherein an inside of the package is hermetically sealed by the envelope. That is to say that the liquid injection head and humidity controlling agent may be hermetically sealed inside the envelope.

### (Configuration 3)

The package according to configuration 1 or 2, wherein the humidity controlling agent includes type-B silica gel.

### (Configuration 4)

The package according to configuration 3, wherein the humidity controlling agent further includes a drying agent that is different from the type-B silica gel.

### (Configuration 5)

The package according to configuration 4, wherein the drying agent is type-A silica gel.

### (Configuration 6)

The package according to configuration 5, wherein a ratio of a weight of the type-B silica gel to a weight of the type-A silica gel is 0.8 or greater and 1.2 or smaller.

### (Configuration 7)

The package according to configuration 5 or 6, wherein the type-B silica gel and the type-A silica gel are wrapped together in a single wrapper. That is to say that a single wrapper may be provided, and the type-B silica gel and the type-B silica gel may be disposed within the single wrapper.

### (Configuration 8)

The package according to any of configurations 1 to 7, wherein a relative humidity inside the envelope is 60% or below.

### (Configuration 9)

The package according to any of configurations 1 to 7, wherein a relative humidity inside a hermetically sealed envelope is 60% or below.

### (Configuration 10)

The package according to any of configurations 1 to 9, wherein the envelope has a gas-barrier capability. That is to say that the envelope may be provided with a gas-barrier capability, preferably a gas-barrier permeability, and more preferable the envelope may comprise materials configured to provide a gas-barrier capability, i.e. comprise gas-barrier materials.

### (Configuration 11)

The package according to any of configurations 1 to 10, wherein the envelope includes aluminum.

### (Configuration 12)

The package according to any of configurations 1 to 11, wherein the envelope includes a multilayer film.

### (Configuration 13)

The package according to any of configurations 1 to 12, further comprising a head case provided inside the envelope and accommodating the liquid ejection head. Put another way, a head case may be provided, the head case being configured to accommodate (or receive) the liquid ejection head and being configured to be received within the envelope.

### (Configuration 14)

The package according to configuration 13, wherein the head case includes pulp mold. That is a mold may be a container shaped or molded to securely receive the liquid ejection head and being made from a pulp material.

### (Configuration 15)

The package according to configuration 13 or configuration 14, wherein the head case includes paper.

### (Configuration 16)

The package according to any one of configurations 13 to 16, wherein the head case includes recycled plastic.

### (Configuration 17)

The package according to any of configurations 1 to 16, wherein the liquid ejection head includes an ejection unit configured to eject liquid; and a supply unit configured to supply the liquid to the ejection unit.

### (Configuration 18)

The package according to configuration 17, wherein the supply unit is configured to cause the liquid to circulate between the supply unit and the ejection unit. Preferably the supply unit is configured to cause liquid to circulate between the supply unit and ejection unit when the liquid ejection head is included in a liquid ejection apparatus.

### (Configuration 19)

The package according to configuration 17 or configuration 18, wherein the supply unit included in the liquid ejection head includes a plurality of supply units.

### EXAMPLES

The present disclosure will further be described in detail with the provision of examples thereof. Note that the present disclosure is not limited to the following examples.

### EXAMPLE 1

The liquid ejection head 1 illustrated in Figs. 2 and 3 was prepared. The liquid ejection head 1 prepared for Example 1 contained pure water inside. The head case 30 employed was molded from polypropylene resin. The envelope 31 employed had a bag structure formed of a multilayer film including a polyethylene terephthalate resin layer, an aluminum layer, a nylon resin layer, and a polypropylene resin layer. The innermost layer of the envelope 31 was the polypropylene resin layer. The polypropylene resin layer served as a thermal fusion layer. The envelope 31 accommodating the humidity controlling agent 32 and the head case 30 having the liquid ejection head 1 inside was hermetically sealed, whereby a package 100 was obtained. The hermetically sealed package 100 was stored for two months in an environment at 60°C in a storage test on the assumption of a logistics environment. Subsequently, the package 100 was further stored for one day at room temperature, and the envelope 31 was opened to check the state of the liquid ejection head 1.

The above verification was conducted while the following conditions were varied: the amount of moisture contained in the liquid ejection head 1 before the long-term storage, the conditions for the humidity controlling agent 32, and the kind of the envelope 31. The results are summarized in Table 1.

### Table 1

**Table 1**

| Condition | Amount of moisture inside head [g] | Humidity controlling material | Drying agent | Corrosion of metal component after storage at 60°C for 2M | Adhesion inside circulation unit | Max relative humidity inside envelope [%] | Min relative humidity inside envelope [%] | Way of packaging of humidity controlling material and drying agent |
|---|---|---|---|---|---|---|---|---|
| 1-1 | 1.5 | Type-B silica gel: 30 g | Type-A silica gel: 30 g | No | No | 29% | 22% | Mixed in one envelope |
| 1-2 | 1.5 | Type-B silica gel: 15 g | Type-A silica gel: 15 g | No | No | 32% | 26% | Mixed in one envelope |
| 1-3 | 1.5 | Type-B silica gel: 5 g | Type-A silica gel: 5 g | No | No | 60% | 32% | Mixed in one envelope |
| 1-4 | 1.5 | Type-B silica gel: 10 g | Type-A silica gel: 10 g | No | No | 48% | 30% | Mixed in one envelope |
| 1-5 | 1.5 | None | None | Yes | None | 100% | - | - |
| 1-6 | 1.5 | None | Type-A silica gel: 30 g | No | NG (Yes) | 100% (slight dew) | - | - |
| 1-7 | 1.5 | Type-B silica gel: 30 g | None | No | No | 65% (only for 4h) | - | - |
| 1-8 | 1.5 | Zeolite: 30 g | Type-A silica gel: 30 g | No | No | - | - | Not mixed |
| 1-9 | 1.5 | Artificial zeolite: 30 g | Type-A silica gel: 30 g | No | No | - | - | Not mixed |
| 1-10 | 1.5 | Zeolite: 30 g | Type-A silica gel: 30 g | No | No | - | - | Not mixed |
| 1-11 | 1.5 | Type-B silica gel: 30 g | Quicklime: 30 g | No | No | - | - | Not mixed |
| 1-12 | 1.5 | Type-B silica gel: 30 g | Calcium chloride: 30 g | No | No | - | - | Not mixed |
| 1-13 | 3 | Type-B silica gel: 30 g | Type-A silica gel: 30 g | None | None | 34% | 25% | Mixed in one envelope |
| 1-14 | 3 | Type-B silica gel: 15 g | Type-A silica gel: 15 g | None | None | 38% | 29% | Mixed in one envelope |
| 1-15 | 3 | Type-B silica gel: 5 g | Type-A silica gel: 5 g | None | None | 80% | 36% | Mixed in one envelope |
| 1-16 | 3 | Type-B silica gel: 10 g | Type-A silica gel: 10 g | None | None | 67% | 40% | Mixed in one envelope |
| 1-17 | 1.5 | Type-B silica gel: 30 g | Type-A silica gel: 30 g | None | None | 29% | 22% | Mixed in one envelope |
| 1-18 | 0.01 | Type-B silica gel: 30 g | Type-A silica gel: 30 g | None | None | 29% | 22% | Mixed in one envelope |

Condition 1-1 employed a liquid ejection head 1 containing 1.5 g of pure water inside, and a humidity controlling agent 32 obtained as a mixture of 30 g of type-B silica gel effective for humidity control and 30 g of type-A silica gel serving as a drying agent. Under Condition 1-1, no corrosion was observed on the components including metal, and no problems were found at locations, such as the ejection ports 13, where liquid was presumed to have been present. On the other hand, under Condition 1-5 where the humidity controlling agent 32 was not packaged together, corrosion was found on the pad portions 211 of the electrical wiring board 210.

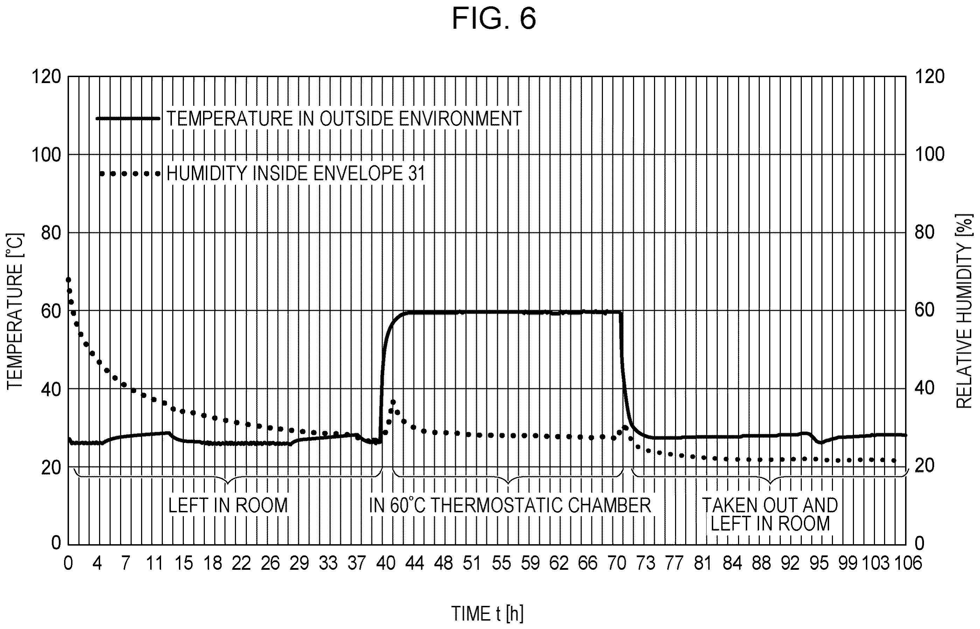

Fig. 6 is a graph illustrating the change in the humidity inside the envelope 31 of the package 100 prepared under Condition 1-1 versus the change in the temperature in an outside environment. The solid line represents the temperature in the outside environment. The broken line represents the humidity inside the envelope 31. In Fig. 6, the left vertical axis represents temperature (°C) and corresponds to the solid line; and the right vertical axis represents relative humidity (%) and corresponds to the broken line. The horizontal axis represents time t. The point where the envelope 31 underwent fusion bonding (the time when the envelope 31 was hermetically sealed) was defined as 0. The thickness of the envelope 31 employed in Example 1 was 95 µm. Therefore, the temperature in the outside environment represented by the solid line is considered to be substantially equal to the temperature inside the envelope 31.

Fig. 6 shows that air at high humidity (70 RH%) was contained in the liquid ejection head 1 in the process of packaging the liquid ejection head 1. This is because in the packaging process, air in an environment where the process is performed is sealed in. That is, a large amount of vapor was present inside the envelope 31. The humidity decreased with time, which shows that the vapor contained in the envelope 31 was gradually removed by the humidity controlling agent 32. In a subsequent environment that was at 60°C, as shown by the graph, the water contained in the liquid ejection head 1 was rapidly gasified (t = 40 to 41). However, the vapor was soon absorbed by the humidity controlling agent 32 (t = 41 to 43), and the inside of the envelope 31 was kept at a low humidity (t = 44 to 70). Even when the temperature was lowered thereafter, substantially no increase in the relative humidity was observed (t = 70 and over) because the amount of vapor inside the envelope 31 was small. To summarize, it has been found that the humidity controlling agent 32 kept the humidity inside the envelope 31 at about 20%.

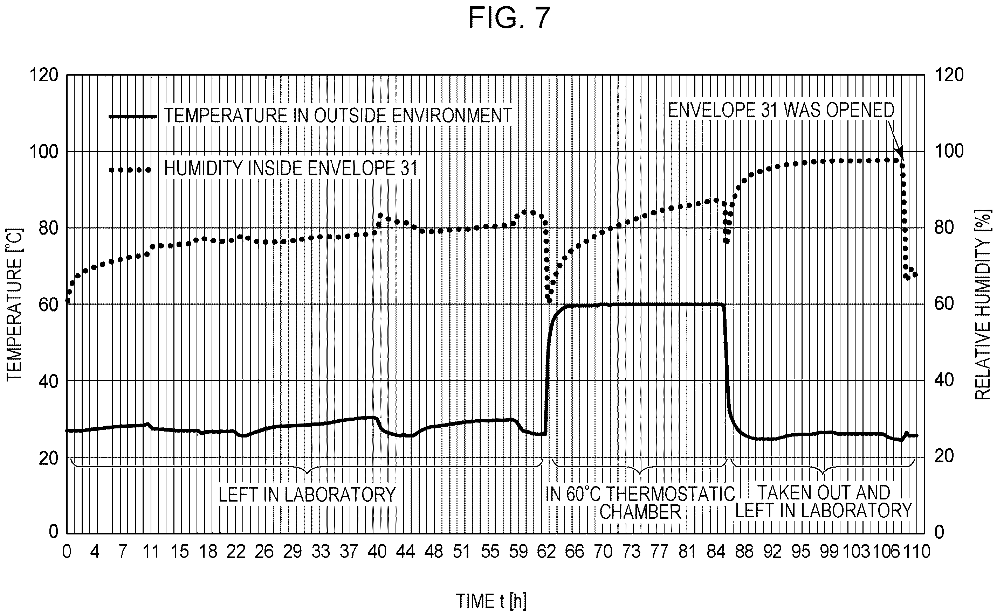

Fig. 7 is a graph illustrating the change in the humidity inside the envelope 31 of the package 100 prepared under Condition 1-5 versus the change in the temperature in an outside environment, and corresponds to the graph in Fig. 6. Specifically, the change in the humidity inside the envelope 31 versus the change in the temperature in the outside environment in a case where the humidity controlling agent 32 was not packaged together. The solid line represents the temperature in the outside environment, and the broken line represents the humidity inside the envelope 31. As with the case of Condition 1-1, the thickness of the envelope 31 employed in Example 1 was 95 µm. Therefore, the temperature in the outside environment represented by the solid line is considered to be substantially equal to the temperature inside the envelope 31.

Fig. 7 shows that air at high humidity (60 RH%) was contained in the liquid ejection head 1 in the process of packaging the liquid ejection head 1. This is because in the packaging process, air in an environment where the process is performed is sealed in. The humidity increased with time, which shows that the amount of vapor inside the envelope 31 increased with the evaporation of the water inside the liquid ejection head 1 that progressed with time. In a subsequent environment that was at 60°C, as shown by the graph, the water contained in the liquid ejection head 1 was rapidly gasified, which further increased the humidity (t = 62 to 86). When the temperature was lowered thereafter, a phenomenon close to dewing occurred and the relative humidity was kept at a high level (t = 86 and over) because the amount of vapor inside the envelope 31 was originally large.

It is known that the speed of corrosion of metals that may be included in the liquid ejection head, such as nickel; copper; cobalt; and/or iron, increases rapidly when the relative humidity exceeds 60%. The pad portions 211 of the liquid ejection head 1 employed in Example 1 each included a copper layer and a nickel layer. Comparing the results illustrated in Figs. 6 and 7, it is considered that putting the humidity controlling agent 32 into the envelope 31 kept the relative humidity at 60% or below and thus prevented the corrosion.

### EXAMPLE 2

As in Example 1, a liquid ejection head that was hermetically packaged in an envelope was prepared. Specifically, the liquid ejection head 1 illustrated in Figs. 2 and 3 was prepared. The liquid ejection head 1 prepared contained pure water inside. The head case 30 employed was a molded product made of polypropylene (PP) resin or pulp mold. The envelope 31 employed had a bag structure formed of a multilayer film including a polyethylene terephthalate resin layer, an aluminum layer, a nylon resin layer, and a polypropylene resin layer. The innermost layer of the envelope 31 was the polypropylene resin layer. The polypropylene resin layer served as a thermal fusion layer. The envelope 31 accommodating the humidity controlling agent 32 and the head case 30 having the liquid ejection head 1 inside was hermetically sealed, whereby a package 100 was obtained. The hermetically sealed package 100 was left for two weeks in an environment at 60°C, and was then left at room temperature for two days. This is a condition that follows a form of logistics for the liquid ejection head.

Subsequently, the envelope 31 was opened, the liquid ejection head 1 was set in an inkjet apparatus illustrated in Fig. 1 as the liquid ejection apparatus 50, and printing was performed. Then, the liquid ejection head 1 was removed from the inkjet apparatus and was put into the head case 30. The liquid ejection head 1 when removed from the inkjet apparatus contained about 15 g of ink inside.

The opened part of the envelope 31 was folded, and the folded part was fixed with cellophane adhesive tape so as not to be unfolded. That is, the inside of the envelope 31 was half open, neither sealed nor fully open. Therefore, the air inside the envelope 31 was moderately influenced by the outside environment.

In this state, the liquid ejection head 1 was stored at 60°C and 90 RH% for four days, following the conditions in the collection logistics for the liquid ejection head.

The above verification was conducted while the following conditions were varied: the amount of moisture contained in the liquid ejection head 1 before the long-term storage, the conditions for the humidity controlling agent 32, and the kind of the envelope 31. The results are summarized in Table 2.

### Table 2

**Table 2**

| Condition | Amount of ink inside head [g] | Material of head case | Humidity controlling material | Drying agent | Corrosion of metal component after storage at 60°C and 90% for 4 days | Adhesion to component/thickening in nozzle after storage at 60°C and 90% for 4 days | Way of packaging of humidity controlling material and drying agent |
|---|---|---|---|---|---|---|---|
| 2-1 | 15 | PP | Type-B silica gel: 30 g | Type-A silica gel: 30 g | No | No | Mixed in one envelope |
| 2-2 | 15 | PP | Type-B silica gel: 15 g | Type-A silica gel: 15 g | No | No | Mixed in one envelope |
| 2-3 | 15 | PP | Type-B silica gel: 5 g | Type-A silica gel: 5 g | No | Thickening in nozzle | Mixed in one envelope |
| 2-4 | 15 | PP | Type-B silica gel: 10 g | Type-A silica gel: 10 g | No | Thickening in nozzle | Mixed in one envelope |
| 2-5 | 15 | PP | None | None | Pad corroded slightly | Adhesion in circulation unit, thickening in nozzle | - |
| 2-6 | 15 | PP | None | Type-A silica gel: 30 g | No | Adhesion in circulation unit, thickening in nozzle | - |
| 2-7 | 15 | PP | Type-B silica gel: 30 g | None | No | No | - |
| 2-8 | 15 | PP | Zeolite: 30 g | Type-A silica gel: 30 g | No | No | Not mixed |
| 2-9 | 15 | PP | Artificial zeolite: 30 g | Type-A silica gel: 30 g | No | No | Not mixed |
| 2-10 | 15 | PP | Zeolite: 30 g | Type-A silica gel: 30 g | No | No | Not mixed |
| 2-11 | 15 | PP | Type-B silica gel: 30 g | Quicklime: 30 g | No | No | Not mixed |
| 2-12 | 15 | PP | Type-B silica gel: 30 g | Calcium chloride: 30 g | No | No | Not mixed |
| 2-13 | 15 | Pulp mold | Type-B silica gel: 30 g | Type-A silica gel: 30 g | No | No | Mixed in one envelope |
| 2-14 | 15 | Pulp mold | Type-B silica gel: 15 g | Type-A silica gel: 15 g | No | No | Mixed in one envelope |
| 2-15 | 15 | Pulp mold | Type-B silica gel: 10 g | Type-A silica gel: 10 g | No | Thickening in nozzle | Mixed in one envelope |
| 2-16 | 15 | Pulp mold | Type-B silica gel: 5 g | Type-A silica gel: 5 g | No | Thickening in nozzle | Mixed in one envelope |
| 2-17 | 15 | Pulp mold | None | None | Pad corroded | Adhesion in circulation unit, thickening in nozzle | - |

Condition 2-1 employed a liquid ejection head 1 containing 15 g of ink inside, and a humidity controlling agent 32 obtained as a mixture of 30 g of type-B silica gel effective for humidity control and 30 g of type-A silica gel serving as a drying agent. Under Condition 2-1, no corrosion was observed on the components including metal, and no problems were found at locations, such as the ejection ports 13, where ink was presumed to have been present. On the other hand, under Condition 2-5 where the humidity controlling agent 32 was not packaged together, corrosion was found on the pad portions 211 of the electrical wiring board 210.

Subsequently, as a condition following another form of collection logistics, the head case 30 having the liquid ejection head 1 inside and the humidity controlling agent 32 were put into the envelope 31 such that a half-open package 100 was obtained. Furthermore, the package 100 was stored at 60°C and 10 RH% for four days. For example, under Condition 2-1 where the humidity controlling agent 32 was packaged together, no corrosion was observed on the metal components, and no problems were found at locations where ink had been present. Although ink was present on the resin member having the ejection ports 13 (nozzles), such ink was easily removed when cleansed thereafter. Hence, the liquid ejection head 1 and the ejection unit 300 collected were able to be recycled.

In contrast, in another liquid ejection head 1 packaged without the humidity controlling agent 32 and stored at 60°C and 90 RH% for four days, thickening and/or partial adhesion of ink was observed concentratedly at the ejection ports 13 (nozzles). In the cleansing process performed thereafter, the ink adhered was not easily removed. Even after the cleansing process, some precipitation was found around the ejection ports 13. Therefore, the ejection unit 300 was unable to be recycled.

In the hermetically sealed state in Example 1 that resembles the logistics environment at the time of shipment, satisfactory amounts of the humidity controlling material and the drying agent were present relative to the amount of moisture inside the liquid ejection head. Therefore, the humidity controlling agent 32 kept the humidity at a low level. That is, the humidity controlling agent 32 exerts moisture absorption even after experiencing a logistics environment (t = 70 and over in Fig. 6). Furthermore, the humidity controlling material, such as type-B silica gel, employed as the humidity controlling agent 32 tends to maintain a humidity state close to that of the environment where the material is placed. Therefore, the humidity controlling material that has experienced the logistics environment memorizes a low humidity. However, since the environment in which the humidity controlling material is placed at the time of the sealing process (t = 0) contains vapor, there is no chance that the type-B silica gel memorizes a humidity as extremely low as a relative humidity of 5% or below.

In the half-open state in Example 2, since a large amount of ink (moisture) is present in the liquid ejection head 1, the humidity inside the envelope 31 tends to increase. When the humidity in the ambient environment is high, the humidity inside the envelope 31 increases to that high level. Under such circumstances, if the humidity controlling agent 32 is packaged together in the envelope 31, the humidity controlling agent 32 tends to reduce the humidity by absorbing the vapor inside the envelope 31 because the humidity controlling agent 32 has the memory of a low humidity. Since the envelope 31 is half open, the humidity controlling agent 32 absorbs vapor in the ambient environment, which is not the vapor generated from the liquid ejection head 1. Nevertheless, the humidity controllability of the humidity controlling agent 32 is maintained for a certain period corresponding to the time to be taken for collection logistics.

In the half-open state in Example 2, if the humidity in the ambient environment is low, the humidity inside the envelope 31 tends to decrease to a level substantially as low as the humidity in the ambient environment. In the collection logistics, the environment inside the envelope 31 is influenced by the outside environment and gradually changes to the environment established at the time of packaging. Nevertheless, the humidity controlling effect of the humidity controlling agent 32 that is present in the envelope 31 reduces the probability that the humidity inside the envelope 31 may become excessively low. At the ejection pots 13 (nozzles), some liquid such as ink is present and is directly in contact with outside air. If such liquid is rapidly dried, the liquid is easily thickened. Even in the half-open state as in Example 2, the humidity controlling agent 32 produces a great effect of slowing the speed of drying of the inside of the envelope 31.

Conditions 2-13 to 2-17 each employed a head case 30 made of pulp mold. Under Condition 2-17 where no humidity controlling agent 32 was packaged together and Condition 2-16 where the total weight of the humidity controlling agent 32 was small relative to the amount of ink inside the head 1, the pulp mold was softened. Accordingly, for Conditions 2-15 and 2-17, an impact absorption test was conducted in which the envelope 31 having the liquid ejection head 1 inside was dropped from different heights of 45 cm, 75 cm, and 90 cm, and the results were evaluated with reference to whether the dropping deformed the external shape of the liquid ejection head 1. The results are summarized in Table 3.

### Table 3

**Table 3**

| Condition | Amount of ink inside head [g] | Material of head case | Humidity controlling material | Drying agent | Drop height [cm] | Deformation of liquid ejection head after drop | Way of packaging of humidity controlling material and drying agent |
|---|---|---|---|---|---|---|---|
| 2-16 | 15 | Pulp mold | Type-B silica gel: 5 g | Type-A silica gel: 5 g | 90 | Yes | Mixed in one envelope |
| | | | | | 75 | No | |
| | | | | | 45 | No | |
| 2-17 | 15 | Pulp mold | None | None | 90 | Yes | - |
| | | | | | 75 | Yes | |
| | | | | | 45 | Yes | |

Under Condition 2-17 where no humidity controlling agent 32 was packaged together, the head 1 was deformed by the dropping from all of the heights. Under Condition 2-16 where the humidity controlling agent 32 was packaged together, the liquid ejection head 1 was deformed by the dropping from 90 cm but was not deformed by the dropping from 75 cm and 45 cm. This shows that the strength of the pulp-mold head case 30 was maintained even under Condition 2-16 where the amount of humidity controlling agent 32 was small. While the head case 30 evaluated in Example 2 was made of pulp mold, the effect of maintaining the strength of the head case 30 is considered to be obtained in other cases such as a case where a shock absorber made of corrugated cardboard or resin is put into the envelope 31.

According to the present disclosure, a highly reliable liquid ejection head is provided.

Various embodiments have been described in detail above but it will be understood that the present disclosure is not limited solely to these embodiments and encompasses all modifications, variants, alternatives and equivalents falling within the scope of the appended claims. Each of the embodiments and configurations described can be implemented solely or as combination of a plurality of the embodiments or configurations or features thereof where necessary or where the combination of elements or features rom individual embodiments or configurations in a single embodiment or configuration is beneficial.

## Claims

1. A liquid-ejection-head package (100) comprising:
a liquid ejection head (1) for operation in a liquid ejection apparatus (50) and being configured to eject liquid;
a humidity controlling agent (32) including type-B silica gel; and
an envelope (31) accommodating the liquid ejection head (1) and the humidity controlling agent (32).

2. The package (100) according to claim 1, wherein an inside of the package (100) is hermetically sealed by the envelope (31).

3. The package (100) according to claim 1 or claim 2, wherein the humidity controlling agent (32) further includes a drying agent that is different from the type-B silica gel.

4. The package (100) according to claim 3, wherein the drying agent is type-A silica gel.

5. The package (100) according to claim 4, wherein a ratio of a weight of the type-B silica gel to a weight of the type-A silica gel is 0.8 or greater and 1.2 or smaller.

6. The package (100) according to claim 4 or claim 5, wherein the type-B silica gel and the type-A silica gel are wrapped together in a single wrapper.

7. The package (100) according to any preceding claim, wherein a relative humidity inside the envelope (31) is 60% or below.

8. The package (100) according to any preceding claim, when dependent on claim 2, wherein a relative humidity inside the hermetically sealed envelope (31) is 60% or below.

9. The package (100) according to any preceding claim, wherein the envelope (31) has a gas-barrier capability.

10. The package (100) according to any preceding claim, wherein the envelope (31) includes aluminum.

11. The package (100) according to any preceding claim, wherein the envelope (31) includes a multilayer film.

12. The package (100) according to any preceding claim, further comprising a head case (30) provided inside the envelope (31) and accommodating the liquid ejection head (1).

13. The package (100) according to claim 12, wherein the head case (30) includes pulp mold.

14. The package (100) according to claim 12 or claim 13, wherein the head case (30) includes paper.

15. The package (100) according to any one of claims 12 to 14, wherein the head case (30) includes recycled plastic.

16. The package (100) according to any preceding claim, wherein the liquid ejection head (1) includes an ejection unit (300) configured to eject liquid; and a supply unit (2) configured to supply the liquid to the ejection unit (300).

17. The package (100) according to claim 16, wherein the supply unit (2) is configured to cause the liquid to circulate between the supply unit (2) and the ejection unit (300).

18. The package (100) according to claim 16 or claim 17, wherein the supply unit (2) included in the liquid ejection head (1) includes a plurality of supply units (2).
